# EUROPEAN PATENT APPLICATION

(11) **EP 4 752 460 A1**
(43) Date of publication of application: **03.06.2026**
(21) Application number: 25219611.8
(22) Date of filing: 30.11.2025
(51) Int. Cl.: F25B 1/053, F25B 5/02, F25B 43/04

(54) **INTEGRATED TWO-PHASE DIRECT-TO-CHIP COOLING USING R718**

(30) Priority: 30.11.2024 US 202463726482 P; 22.11.2025 US 202519397869
(71) Applicant: Vertiv International GmbH, 8212 Neuhausen am Rheinfall (CH)
(72) Inventor: BISARRO, Carlo, Westerville, 43082 (US); PARISE, Andrea, Westerville, 43082 (US); TAMMARO, Marcello, Westerville, 43082 (US)
(74) Representative: Bryn-Jacobsen, Caelia

(57) **Abstract**

A cooling system can include an enclosure, a first condenser, a compressor, an evaporator fluidically coupled to the condenser, a first pump for circulating a refrigerant through a plurality of cold plates, a heat exchanger fluidically coupled to the condenser, and a second pump for circulating the refrigerant through the heat exchanger. The first pump can selectively pump the refrigerant from the first condenser and/or the evaporator. The system can circulate the refrigerant through the first condenser, the compressor, the evaporator, the first pump, the heat exchanger, the second pump, or a combination thereof. The refrigerant can be de-ionized water and/or R718.

## Description

### CROSS-REFERENCE TO RELATED APPLICATION(S)

This application claims the benefit of U.S. Provisional Patent Application No. 63/726,482 filed November 30, 2024.

### TECHNICAL FIELD

The present disclosure relates generally to cooling systems, such as for use with data centers, and more specifically relates to two-phase direct-to-chip cooling systems.

### BACKGROUND

Direct-to-chip cooling systems, such as those for use with data centers, are often based on a pumped refrigerant loop to supply an engineered liquid refrigerant, with their inherent limitations and problems, to chip-mounted cold plates. Such systems typically use chillers that are decoupled from the refrigerant loop. Vapor or vapor-mix refrigerant from the chip-mounted cold plates is sent to a condenser for subcooling to feed the pump with liquid, avoiding cavitation. To ensure sufficient liquid phase refrigerant to the pump, a low approach temperature is required at the condenser, which requires an even lower evaporation temperature at the chillers. Furthermore, typical pumped refrigerant loops tend to over-feed liquid refrigerant to the cold plates, to cover eventual load spikes. However, this typically results in only partial evaporation, with liquid refrigerant exiting the cold plates, which can cause lower condenser performance and wasted energy consumption by the refrigerant pumps.

### SUMMARY

Applicant has created new and useful devices, systems and methods for two-phase direct-to-chip cooling systems. In at least one example, a cooling system according to the disclosure can include an integrated chiller and pumped refrigerant unit utilizing R718 as a refrigerant in both a chiller and as a pumped refrigerant through cold plates, in a single hydraulic loop. In at least one example, the cooling system can provide for the use of lower refrigerant volumes, lower vapor flow rates and more compact and efficient centrifugal compressors, versus conventional cooling systems.

In at least one example, a cooling system according to the disclosure can include an enclosure, a first condenser disposed at least partially within the enclosure for condensing a refrigerant, a compressor disposed at least partially within the enclosure for compressing the refrigerant, an evaporator disposed at least partially within the enclosure and/or fluidically coupled to the first condenser, a first pump disposed at least partially within the enclosure for circulating the refrigerant through a plurality of cold plates, a heat exchanger disposed at least partially within the enclosure and/or fluidically coupled to the condenser, a second pump disposed at least partially within the enclosure for circulating the refrigerant through the heat exchanger, or any combination thereof.

In at least one example, the first pump can selectively pump the refrigerant from the first condenser and/or the evaporator. In at least one example, the first pump can pump the refrigerant from the first condenser to the plurality of cold plates when the compressor is disengaged, such as when the cooling system is operating in free cooling mode. In at least one example, the first pump can pump the refrigerant from the evaporator to the plurality of cold plates when the compressor is engaged, such as when the cooling system is operating in compression mode.

In at least one example, the system can circulate the same refrigerant through the first condenser, the compressor, the evaporator, the first pump, the heat exchanger, the second pump, or any combination thereof. In at least one example, the refrigerant can be de-ionized water and/or comport with an American Society of Heating, Refrigerating and Air-Conditioning Engineers (ASHRAE) standard, such as standard 34 for R718 refrigerant.

In at least one example, the first condenser can be a direct contact condenser. In at least one example, the system can include a vacuum sub-system for extracting incondensable gasses and/or contaminants from the first condenser. In at least one example, the vacuum sub-system can include a second condenser disposed at least partially within the enclosure for condensing the refrigerant and/or a vacuum pump disposed at least partially within the enclosure for drawing the incondensable gasses into the second condenser or another component of the vacuum sub-system. In at least one example, the first pump can pump the refrigerant, in liquid form, from the second condenser to the plurality of cold plates.

In at least one example, the compressor can be a centrifugal compressor. In at least one example, the compressor can receive the refrigerant, in vapor form, from the cold plates and/or compress the refrigerant entering the first condenser.

In at least one example, the second pump can selectively pump the refrigerant from the first condenser, such as from below a liquid surface of the refrigerant in the first condenser, through the heat exchanger, and back to the first condenser, such as above the liquid surface. In at least one example, the system can include a plurality of spray nozzles disposed at least partially within the first condenser, above the liquid surface, for dispersing the refrigerant entering the first condenser from the heat exchanger.

In at least one example, the system can include an overpressure sub-system disposed at least partially within the enclosure for receiving excess refrigerant, in liquid form, from the cold plates, such as upstream of the cold plates. In at least one example, the overpressure sub-system can selectively direct the excess refrigerant to the first condenser and/or the evaporator.

In at least one example, the system can include a vapor collector disposed at least partially within the enclosure for receiving the refrigerant, in vapor form, from the cold plates. In at least one example, the vapor collector can selectively direct the refrigerant to the first condenser and/or the compressor.

In at least one example, the system can include a filtration sub-system disposed at least partially within the enclosure for minimizing impurities within the refrigerant. In at least one example, the filtration sub-system can include one or more media filters and/or one or more ultra-violet lights. In at least one example, the filtration sub-system can be fluidically coupled between the first pump and the cold plates.

In at least one example, the heat exchanger can transfer heat from the refrigerant to a cooling fluid. In at least one example, any or all of the cooling fluid can be circulated through an external heat exchanger positioned outside a building housing the system. In at least one example, the external heat exchanger can reject any or all of the heat extracted from the cold plates into an environment outside of the building. In at least one example, any or all of the cooling fluid can be circulated through a heat recovery device inside a building housing the system. In at least one example, the heat recovery device can reject any or all of the heat extracted from the cold plates into the building outside of the system such as outside the enclosure and/or outside a room housing the system and/or the cold plates.

### BRIEF DESCRIPTION OF THE DRAWINGS

FIG. 1 is a schematic view of one of many examples of a cooling system according to the disclosure.
FIG. 2 is a schematic view of the cooling system of FIG. 1 showing one illustrative flow configuration.
FIG. 3 is a schematic view of the cooling system of FIG. 1 showing another illustrative flow configuration.
FIG. 4 is a perspective view of another one of many examples of a cooling system according to the disclosure.

### DETAILED DESCRIPTION

The figures described above and the written description of specific structures and functions below are not presented to limit the scope of what Applicant has invented or the scope of the appended claims. Rather, the figures and written description are provided to teach any person skilled in the art to make and use the inventions for which patent protection is sought. Persons of skill in this art will also appreciate that the development of commercial example may require numerous implementation-specific decisions to achieve the developer's ultimate goal for the commercial example. Such implementation-specific decisions may include, and likely are not limited to, compliance with system-related, business-related, government-related and other constraints, which may vary by specific implementation, location and from time to time. While a developer's efforts might be complex and time-consuming in an absolute sense, such efforts would be, nevertheless, a routine undertaking for those of skill in this art having benefit of this disclosure. It must be understood that the inventions disclosed and taught herein are susceptible to numerous and various modifications and alternative forms.

The use of a singular term, such as, but not limited to, "a," is not intended as limiting of the number of items. Also, the use of relational terms, such as, but not limited to, "top," "bottom," "left," "right," "upper," "lower," "down," "up," "side," and the like are used in the written description for clarity in specific reference to the figures and are not intended to limit. The terms "including" and "such as" are illustrative and not limitative. The terms "couple," "coupled," "coupling," "coupler," and like terms are used broadly herein and can include any method or device for securing, binding, bonding, fastening, attaching, joining, inserting therein, forming thereon or therein, communicating, or otherwise associating, for example, mechanically, magnetically, electrically, chemically, operably, directly or indirectly with intermediate elements, one or more pieces of members together and can further include without limitation integrally forming one functional member with another in a unity fashion. The coupling can occur in any direction, including rotationally. Further, all parts and components of the disclosure that are capable of being physically embodied inherently include imaginary and real characteristics regardless of whether such characteristics are expressly described herein, including but not limited to characteristics such as axes, ends, inner and outer surfaces, interior spaces, tops, bottoms, sides, boundaries, dimensions (e.g., height, length, width, thickness), mass, weight, volume and density, among others.

Applicant has created new and useful devices, systems and methods for two-phase direct-to-chip cooling systems. In at least one example, a cooling system according to the disclosure can include an integrated chiller and pumped refrigerant unit utilizing R718 as a refrigerant in both a chiller and as a pumped refrigerant through cold plates, in a single hydraulic loop. In at least one example, the cooling system can provide for the use of lower refrigerant volumes, lower vapor flow rates and more compact and efficient centrifugal compressors, versus conventional cooling systems.

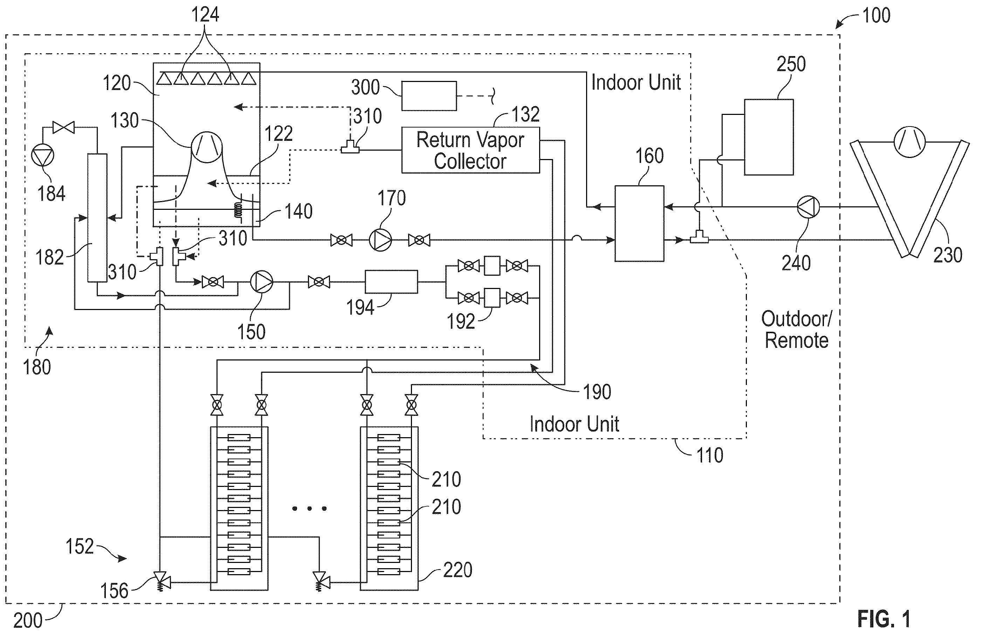

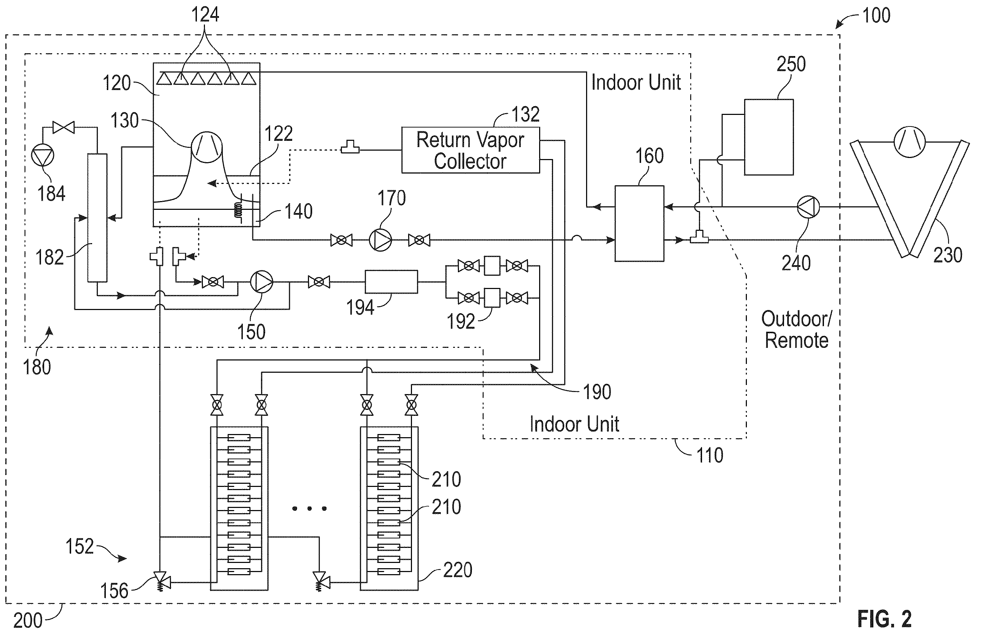

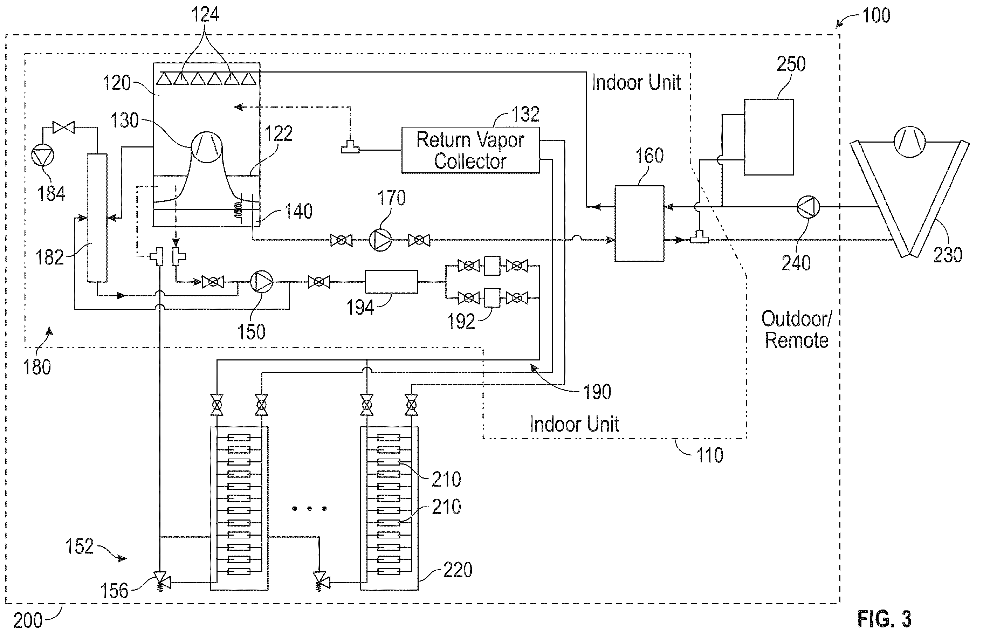

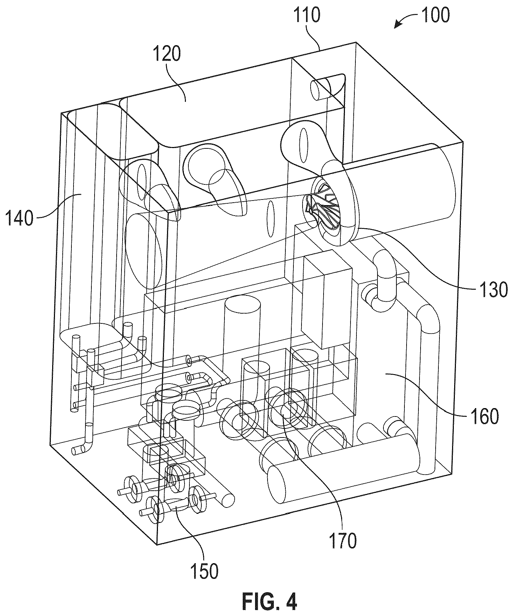

FIG. 1 is a schematic view of one of many examples of a cooling system according to the disclosure. FIG. 2 is a schematic view of the cooling system of FIG. 1 showing one illustrative flow configuration. FIG. 3 is a schematic view of the cooling system of FIG. 1 showing another illustrative flow configuration. FIG. 4 is a perspective view of another one of many examples of a cooling system according to the disclosure. FIGS. 1-4 are described in conjunction with one another.

In at least one example, a cooling system 100 according to the disclosure can include one or more enclosures 110, one or more condensers 120 disposed at least partially within the enclosure 110 for condensing a refrigerant, one or more compressors 130 disposed at least partially within the enclosure 110 for compressing the refrigerant, one or more evaporators 140 disposed at least partially within the enclosure 110 and/or fluidically coupled to the condenser 120, one or more circulation pumps 150 disposed at least partially within the enclosure 110 for circulating the refrigerant through one or more cold plates 210, one or more heat exchangers 160 disposed at least partially within the enclosure 110 and/or fluidically coupled to the condenser 120, one or more cooling pumps 170 disposed at least partially within the enclosure 110 for circulating the refrigerant through the heat exchanger 160, or any combination thereof.

In at least one example, the circulation pump 150 can selectively pump the refrigerant from the condenser 120 and/or the evaporator 140. In at least one example, the circulation pump 150 can pump the refrigerant from the condenser 120 to the plurality of cold plates 210 when the compressor 130 is disengaged, such as when the cooling system 100 is operating in free cooling mode. In at least one example, the circulation pump 150 can pump the refrigerant from the evaporator 140 to the plurality of cold plates 210 when the compressor 130 is engaged, such as when the cooling system 100 is operating in compression mode.

In at least one example, the system 100 can avoid problems with engineered fluids, such as flammability, toxicity, inefficiencies, such as high operating pressures, and expense. In at least one example, the refrigerant can be de-ionized water and/or comport with an American Society of Heating, Refrigerating and Air-Conditioning Engineers (ASHRAE) standard, such as standard 34 for R718 refrigerant.

In at least one example, the system 100 can circulate the same refrigerant through the condenser 120, the compressor 130, the evaporator 140, the circulation pump 150, the heat exchanger 160, the cooling pump 170, the cold plates 210, or any combination thereof. In at least one example, the system 100 can circulate the same refrigerant through each of the condenser 120, the compressor 130, the evaporator 140, the circulation pump 150, the heat exchanger 160, the cooling pump 170, and the cold plates 210. In at least one example, the circulation pump 150 and/or the compressor 130 can circulate a portion of the refrigerant through the compressor 130, the evaporator 140, the circulation pump 150, and the cold plates 210 while, at the same time, the cooling pump 170 can pump another portion of the same refrigerant through the condenser 120, the heat exchanger 160, and the cooling pump 170. In at least one example, the circulation pump 150 can pump a portion of the refrigerant through the condenser 120, the evaporator 140, the circulation pump 150, and the cold plates 210 while, at the same time, the cooling pump 170 can pump another portion of the same refrigerant through the condenser 120, the heat exchanger 160, and the cooling pump 170. In at least one example, the condenser 120 can be a direct contact condenser.

In at least one example, the cold plates 210 can be thermally coupled with one or more electronic devices (e.g., information technology (IT) equipment) for cooling the devices, such as in one or more computer equipment cabinets 220, which can be separate from and/or independent of the enclosure 110. In at least one example, the cold plates 210 can be pool boiling cold plates with water level regulation. In at least one example, the enclosure 110 can be collocated with, or coupled to, one or more cabinets 220 or be located remotely from the cabinets 220. In at least one example, the enclosure 110 and/or the cabinets 220 can be located within a computer room and/or another portion of a building 200.

In at least one example, the system 100 can include a vacuum sub-system 180 for selectively maintaining an interior of the tank 110 and/or any related plumbing or other components at a pressure below the ambient pressure surrounding the tank 110. In at least one example, the vacuum sub-system 180 can include a condenser 182 for condensing the refrigerant 120 and/or a vacuum pump 184, such as for drawing a vacuum within the system 100 before charging the system with refrigerant and/or extracting incondensable gasses. In at least one example, the vacuum sub-system 180 can be at least partially disposed within the enclosure 160. In at least one example, the condenser 182 and/or the vacuum pump 184 can be at least partially disposed within the enclosure 160. In at least one example, the vacuum sub-system 180 can extract incondensable gasses and/or contaminants that leak into the tank 110, such as due to the tank 110 operating at sub-ambient and/or sub-atmospheric pressure. In at least one example, if water vapor is inadvertently collected by the vacuum pump 184, it can be condensed by the condenser 182. In at least one example, the circulation pump 150 can pump the refrigerant, in liquid form, from the condenser 182 of the vacuum sub-system 180. In at least one example, the circulation pump 150 can supply the refrigerant to the cold plates 210 closer to, at, or above atmospheric pressure, while the condenser 120 can be maintained at a sub-atmospheric pressure.

In at least one example, the compressor 130 can be or include one or more centrifugal compressors operating in a single stage and/or multiple stages. In at least one example, the compressor 130 can receive the refrigerant, in vapor form, from the cold plates 210 and/or compress the refrigerant entering the condenser 120. In at least one example, the system 100 can include one or more additional compression stages (not shown), which can, but need not, take place in an enclosure or housing separate from condenser 120. For example, in at least one example, the system 100 can include a flash evaporator, refrigerant from condenser 120 can be routed to the flash evaporator, and then resulting refrigerant vapor can undergo another compression stage. As another example, in at least one example, the system 100 can include an intercooler, refrigerant from compressor 130 can be routed to the intercooler (e.g., via a compressor discharge line), and then resulting refrigerant vapor can undergo another compression stage.

In at least one example, the cooling pump 170 can selectively pump the refrigerant from the condenser 120, such as from below a liquid surface 122 of the refrigerant in the condenser 120, through the heat exchanger 160, and back to the condenser 120, such as above the liquid surface 122. In at least one example, the system 100 can include one or more spray nozzles 124 disposed at least partially within the condenser 120, such as above the liquid surface 122, for dispersing the refrigerant entering the condenser 120 from the heat exchanger 160.

In at least one example, the system 100 can include one or more overpressure sub-systems 152 disposed at least partially within the enclosure 110 for receiving excess refrigerant, in liquid form, from the cold plates 210, such as upstream of the cold plates 210. In at least one example, the system 100 can over-flow the cold plates 210 and ensure that only a needed amount of refrigerant enters the cold plates 210 and/or that the refrigerant exiting the cold plates 210 be in vapor form, for return to the compressor 130. In at least one example, the overpressure sub-system 152 can selectively direct the excess refrigerant to the condenser 120 and/or the evaporator 140. In at least one example, the overpressure sub-system 152 can reduce energy waste by the circulation pump 150. In at least one example, the overpressure sub-system 152 can include one or more valves, such as one or more pressure relief valves 156 and/or other valves, one or more manifolds, piping between the condenser 120, the evaporator 140, and the cold plates 210, or any combination thereof.

In at least one example, the system 100 can include one or more vapor collectors 132 disposed at least partially within the enclosure 110 for receiving the refrigerant, in vapor form, from the cold plates 210. In at least one example, the vapor collector 132 can selectively direct the refrigerant to the condenser 120, the compressor 130, the evaporator 140, or any combination thereof. In at least one example, the vapor collector 132 can include one or more vapor ducts and/or one or more valves, such as butterfly valves. In at least one example, the system 100 can efficiently supply the cold plates 210 with the refrigerant in liquid form, minimizing supply flow rates and/or utilizing small supply lines, maximize vaporization of the refrigerant in the cold plates 210, and receive the refrigerant downstream of the cold plates 210 in vapor form. In at least one example, the system 100 can utilize the high latent heat of water, maximizing efficient cooling of the cold plates 210.

In at least one example, the system 100 can include one or more filtration sub-systems 190 disposed at least partially within the enclosure 110 for minimizing impurities within the refrigerant. In at least one example, the filtration sub-system 190 can include one or more media filters 192 and/or one or more ultra-violet lights 194. In at least one example, the filtration sub-system 190 can be fluidically coupled between the circulation pump 150 and the cold plates 210.

In at least one example, the heat exchanger 160 can be a brazed plate heat exchanger. In at least one example, the heat exchanger 160 can transfer heat from the refrigerant to one or more cooling fluids. In at least one example, any or all of the cooling fluid can be circulated through one or more external heat exchangers 230, such as by one or more rejection pumps 240, either or both of which can be positioned outside a building 200 housing the system 100. In at least one example, the external heat exchanger 230 can be or include a dry cooler, a chiller, a condenser, or any combination thereof. In at least one example, the external heat exchanger 230 can reject any or all of the heat extracted from the cold plates 210 into an environment outside of the building 200. In at least one example, any or all of the cooling fluid can be circulated through one or more heat recovery devices 250 inside a building 200 housing the system 200. In at least one example, the heat recovery device 250 can be or include one or more heat exchangers, such as one or more fluid-to-air heat exchangers, and/or can reject any or all of the heat extracted from the cold plates 210 into the building 200, such as outside of the enclosure 110 and/or outside a room housing the system 100 and/or the cold plates 210 (e.g., for utilizing recovered heat to heat another portion of the building).

In at least one example, the system 100 can include one or more controllers 300 for controlling any or all of the compressors 130, the pumps 150, 170, 184, 240, and one or more valves, such as one or more diverter valves 310, and/or one or more other components as required or desired in accordance with a given implementation of the disclosure. In at least one example, the controller 300 can be included in or communicate with one or more supervisory systems, such as to maintain a refrigerant supply temperature to the cold plates 210, and/or one or more building management systems, such as to control one or more functions of the external heat exchanger 230, rejection pump 240, the heat recovery device 250, or any combination thereof. In at least one example, the controller 300 can include one or more user interfaces to communicate with one or more users, such as for setting a refrigerant supply temperature to the cold plates 210 and/or a building temperature to be maintained by the heat recovery device 250.

In at least one example, the controller 300 can control the diverter valves 310 and the circulation pump 150 to draw the refrigerant from the evaporator 140 and/or the condenser 120 and return excess refrigerant to the evaporator 140 and/or the condenser 120. In at least one example, the controller 300 can control the diverter valves 310 and the circulation pump 150 to draw the refrigerant from the evaporator 140 and return excess refrigerant to the evaporator 140, such as when demand is high and the system 100 is operating in a direct expansion or compression mode, such as when the compressor 130 is engaged and compressing the refrigerant (in a vapor phase) in the condenser 120. In at least one example, the controller 300 can control the diverter valves 310 and the circulation pump 150 to draw the refrigerant from the condenser 120 and return excess refrigerant to the condenser 120, such as when demand is low and the system 100 is operating in a free cooling mode, such as when the compressor 130 is disengaged. In at least one example, the controller 300 can control the diverter valves 310 and the cooling pump 170 to draw the refrigerant from the condenser 120, such as below the liquid surface 122, and direct the refrigerant, such as in vapor form, into the condenser 120 and/or the compressor 130.

As will be appreciated by those skilled in the art having the benefits of the present disclosure, aspects of one or more examples of the disclosure can be embodied as a system, method or computer program product. Accordingly, aspects of the present examples can take the form of an entirely hardware example, an entirely software example (including firmware, resident software, micro-code, etc.) or an example combining software and hardware aspects that may all generally be referred to herein as a "circuit," "module" or "system." Furthermore, aspects of the present disclosure may take the form of a computer program product embodied in one or more non-transitory computer readable mediums having computer readable program code embodied thereon. Any combination of one or more computer readable media may be utilized. The computer readable media may be a computer readable signal medium or a computer readable storage medium. A computer readable storage medium may be, for example, but not limited to, an electronic, magnetic, optical, electromagnetic, infrared, or semiconductor system, apparatus, or device, or any suitable combination of the foregoing. More specific examples of such computer readable storage media include but are not limited to the following: an electrical connection having one or more wires, a portable computer diskette, a hard disk, a random access memory (RAM), a read-only memory (ROM), an erasable programmable read-only memory (EPROM or Flash memory), an optical fiber, a portable compact disc read-only memory (CD-ROM), an optical storage device, a magnetic storage device, or any suitable combination of the foregoing. In the context of this document, a computer readable storage medium may be any tangible medium that can contain or store a program for use by or in connection with an instruction execution system, apparatus, or device.

Program code embodied on a computer readable medium may be transmitted using any appropriate medium or media, including but not limited to wireless, wireline, optical fiber cable, radio frequency (RF), or any suitable combination of the foregoing. Computer program code for carrying out operations for aspects of the present disclosure may be written in any combination of one or more programming languages, including an object oriented programming language such as Java, Smalltalk, C++ or the like and conventional procedural programming languages, such as the "C" programming language or similar programming languages. The program code may execute entirely on a user's computer, partly on a user's computer, as a stand-alone software package, partly on a user's computer and partly on a remote computer, or entirely on a remote computer or server. In the latter scenario, the remote computer may be connected to a user's computer through any type of network, including a local area network (LAN) or a wide area network (WAN), or the connection may be made to an external computer (for example, through the Internet using an Internet Service Provider or via a short-range wireless interconnection such as Bluetooth).

Aspects of the present disclosure can be described with reference to flowchart illustrations and/or block diagrams of methods, apparatuses (devices and systems) and computer program products according to examples of the disclosure. Each block of a flowchart illustration and/or block diagram, and combinations of blocks in a flowchart illustration and/or block diagrams, can be implemented by computer program instructions. These computer program instructions may be provided to a processor of a general purpose computer, special purpose computer, or other programmable data processing apparatus to produce a machine, such that the instructions, which executed via one or more processors, create means for implementing the functions/acts specified in the flowchart and/or block diagram block or blocks. The computer program instructions can be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks. The computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in a flowchart and/or block diagram block or blocks. Each block in a flowchart and/or block diagram can be split into multiple blocks and/or combined with other blocks to make a single block.

In at least one example, a cooling system according to the disclosure can include an enclosure, a first condenser disposed at least partially within the enclosure for condensing a refrigerant, a compressor disposed at least partially within the enclosure for compressing the refrigerant, an evaporator disposed at least partially within the enclosure and/or fluidically coupled to the first condenser, a first pump disposed at least partially within the enclosure for circulating the refrigerant through a plurality of cold plates, a heat exchanger disposed at least partially within the enclosure and/or fluidically coupled to the condenser, a second pump disposed at least partially within the enclosure for circulating the refrigerant through the heat exchanger, or any combination thereof.

In at least one example, the first pump can selectively pump the refrigerant from the first condenser and/or the evaporator. In at least one example, the first pump can pump the refrigerant from the first condenser to the plurality of cold plates when the compressor is disengaged, such as when the cooling system is operating in free cooling mode. In at least one example, the first pump can pump the refrigerant from the evaporator to the plurality of cold plates when the compressor is engaged, such as when the cooling system is operating in compression mode.

In at least one example, the system can circulate the same refrigerant through the first condenser, the compressor, the evaporator, the first pump, the heat exchanger, the second pump, or any combination thereof. In at least one example, the refrigerant can be de-ionized water and/or comport with an American Society of Heating, Refrigerating and Air-Conditioning Engineers (ASHRAE) standard, such as standard 34 for R718 refrigerant.

In at least one example, the first condenser can be a direct contact condenser. In at least one example, the system can include a vacuum sub-system for extracting incondensable gasses and/or contaminants from the first condenser. In at least one example, the vacuum sub-system can include a second condenser disposed at least partially within the enclosure for condensing the refrigerant and/or a vacuum pump disposed at least partially within the enclosure for drawing the incondensable gasses into the second condenser or another component of the vacuum sub-system. In at least one example, the first pump can pump the refrigerant, in liquid form, from the second condenser to the plurality of cold plates.

In at least one example, the compressor can be a centrifugal compressor. In at least one example, the compressor can receive the refrigerant, in vapor form, from the cold plates and/or compress the refrigerant entering the first condenser.

In at least one example, the second pump can selectively pump the refrigerant from the first condenser, such as from below a liquid surface of the refrigerant in the first condenser, through the heat exchanger, and back to the first condenser, such as above the liquid surface. In at least one example, the system can include a plurality of spray nozzles disposed at least partially within the first condenser, above the liquid surface, for dispersing the refrigerant entering the first condenser from the heat exchanger.

In at least one example, the system can include an overpressure sub-system disposed at least partially within the enclosure for receiving excess refrigerant, in liquid form, from the cold plates, such as upstream of the cold plates. In at least one example, the overpressure sub-system can selectively direct the excess refrigerant to the first condenser and/or the evaporator.

In at least one example, the system can include a vapor collector disposed at least partially within the enclosure for receiving the refrigerant, in vapor form, from the cold plates. In at least one example, the vapor collector can selectively direct the refrigerant to the first condenser and/or the compressor.

In at least one example, the system can include a filtration sub-system disposed at least partially within the enclosure for minimizing impurities within the refrigerant. In at least one example, the filtration sub-system can include one or more media filters and/or one or more ultra-violet lights. In at least one example, the filtration sub-system can be fluidically coupled between the first pump and the cold plates.

In at least one example, the heat exchanger can transfer heat from the refrigerant to a cooling fluid. In at least one example, any or all of the cooling fluid can be circulated through an external heat exchanger positioned outside a building housing the system. In at least one example, the external heat exchanger can reject any or all of the heat extracted from the cold plates into an environment outside of the building. In at least one example, any or all of the cooling fluid can be circulated through a heat recovery device inside a building housing the system. In at least one example, the heat recovery device can reject any or all of the heat extracted from the cold plates into the building outside of the system such as outside the enclosure and/or outside a room housing the system and/or the cold plates.

Other and further examples utilizing one or more aspects of the disclosure can be devised without departing from the Applicant's disclosure. For example, the devices, systems and methods can be implemented for numerous different types and sizes in numerous different industries. Further, the various methods and examples of the devices, systems and methods can be included in combination with each other to produce variations of the disclosed methods and examples. Discussion of singular elements can include plural elements and vice versa. The order of steps can occur in a variety of sequences unless otherwise specifically limited. The various steps described herein can be combined with other steps, interlineated with the stated steps, and/or split into multiple steps. Similarly, elements have been described functionally and can be embodied as separate components or can be combined into components having multiple functions.

Further examples are set out in the clauses below:
1. A cooling system comprising:
   an enclosure;
   a first condenser disposed at least partially within the enclosure and configured to
   condense a refrigerant;
   a compressor disposed at least partially within the enclosure and configured to selectively compress the refrigerant;
   an evaporator disposed at least partially within the enclosure;
   a first pump disposed at least partially within the enclosure and configured to:
      selectively pump the refrigerant from the first condenser to a plurality of cold plates; and
      selectively pump the refrigerant from the evaporator to the plurality of cold plates;
      a heat exchanger disposed at least partially within the enclosure and fluidically coupled to the first condenser; and
      a second pump disposed at least partially within the enclosure and configured to selectively pump the refrigerant from the first condenser to the heat exchanger for cooling the refrigerant.
2. The cooling system as set forth in clause 1, wherein the system is configured to circulate the refrigerant through the first condenser, the compressor, the evaporator, the first pump, the heat exchanger, and the second pump.
3. The cooling system as set forth in any one of the preceding clauses, wherein the refrigerant is de-ionized water.
4. The cooling system as set forth in any one of the preceding clauses, wherein the refrigerant comports with an American Society of Heating, Refrigerating and Air-Conditioning Engineers (ASHRAE) standard 34 for R718 refrigerant.
5. The cooling system as set forth in any one of the preceding clauses, wherein the first condenser is a direct contact condenser.
6. The cooling system as set forth in any one of the preceding clauses, further comprising a vacuum sub-system configured to extract incondensable gasses and/or contaminants from the first condenser.
7. The cooling system as set forth in clause 6, wherein the vacuum sub-system comprises:
   a second condenser disposed at least partially within the enclosure and configured to condense the refrigerant; and
   a vacuum pump disposed at least partially within the enclosure and configured to draw the incondensable gasses into the second condenser.
8. The cooling system as set forth in any one of the preceding clauses, wherein the first pump is configured to pump the refrigerant from the first condenser to the plurality of cold plates when the compressor is disengaged and the cooling system is operating in free cooling mode; and wherein the first pump is configured to pump the refrigerant from the evaporator to the plurality of cold plates when the compressor is engaged and the cooling system is operating in compression mode.
9. The cooling system as set forth in any one of the preceding clauses, wherein the compressor is a centrifugal compressor.
10. The cooling system as set forth in any one of the preceding clauses, wherein the compressor is configured to receive the refrigerant, in vapor form, from the plurality of cold plates and compress the refrigerant fluidically upstream of the first condenser.
11. The cooling system as set forth in any one of the preceding clauses, wherein the second pump is configured to selectively pump the refrigerant from a first point below a liquid surface of the refrigerant in the first condenser, through the heat exchanger, and to a second point above the liquid surface of the refrigerant in the first condenser.
12. The cooling system as set forth in clause 11, further comprising a plurality of spray nozzles disposed at least partially within the first condenser, above the liquid surface, and configured to disperse the refrigerant entering the first condenser from the heat exchanger.
13. The cooling system as set forth in any one of the preceding clauses, further comprising an overpressure sub-system disposed at least partially within the enclosure and configured to receive excess refrigerant, in liquid form, from upstream of the plurality of cold plates and selectively direct the excess refrigerant to the first condenser or the evaporator.
14. The cooling system as set forth in any one of the preceding clause, further comprising a vapor collector disposed at least partially within the enclosure and configured to receive the refrigerant, in vapor form, from the plurality of cold plates and selectively direct the refrigerant to the first condenser or the compressor.
15. The system as set forth in any one of the preceding clauses, further comprising a filtration sub-system disposed at least partially within the enclosure.
16. The system as set forth in clause 15, wherein the filtration sub-system includes at least one media filter and at least one ultra-violet light.
17. The system as set forth in clause 15, wherein the filtration sub-system is fluidically coupled between the first pump and the plurality of cold plates.
18. The system as set forth in any one of the preceding clauses, wherein the heat exchanger is configured to transfer heat from the refrigerant to a cooling fluid.
19. The system as set forth in clause 18, further comprising an external heat exchanger configured to reject, via the cooling fluid, at least a portion of the heat from the refrigerant into an environment outside of a building that houses the enclosure.
20. The system as set forth in clause 18, further comprising a heat recovery device configured to reject, via the cooling fluid, at least a portion of the heat from the refrigerant into a building that houses the enclosure.

Obvious modifications and alterations to the described examples are available to those of ordinary skill in the art having the benefits of the present disclosure. The disclosed and undisclosed examples are not intended to limit or restrict the scope or applicability of the inventions conceived of by the Applicant, but rather, in conformity with the patent laws, Applicant intends to fully protect all such modifications and improvements that come within the scope or range of equivalents of the following claims.

## Claims

1. A cooling system comprising:
an enclosure;
a first condenser disposed at least partially within the enclosure and configured to condense a refrigerant;
a compressor disposed at least partially within the enclosure and configured to selectively compress the refrigerant;
an evaporator disposed at least partially within the enclosure;
a first pump disposed at least partially within the enclosure and configured to:
selectively pump the refrigerant from the first condenser to a plurality of cold plates; and
selectively pump the refrigerant from the evaporator to the plurality of cold plates;
a heat exchanger disposed at least partially within the enclosure and fluidically coupled to the first condenser; and
a second pump disposed at least partially within the enclosure and configured to selectively pump the refrigerant from the first condenser to the heat exchanger for cooling the refrigerant.

2. The cooling system as set forth in claim 1, wherein the system is configured to circulate the refrigerant through the first condenser, the compressor, the evaporator, the first pump, the heat exchanger, and the second pump.

3. The cooling system as set forth in any one of the preceding claims, wherein the refrigerant is de-ionized water.

4. The cooling system as set forth in any one of the preceding claims, wherein the refrigerant comports with an American Society of Heating, Refrigerating and Air-Conditioning Engineers (ASHRAE) standard 34 for R718 refrigerant.

5. The cooling system as set forth in any one of the preceding claims, wherein the first condenser is a direct contact condenser.

6. The cooling system as set forth in any one of the preceding claims, further comprising a vacuum sub-system configured to extract incondensable gasses and/or contaminants from the first condenser.

7. The cooling system as set forth in claim 6, wherein the vacuum sub-system comprises:
a second condenser disposed at least partially within the enclosure and configured to condense the refrigerant; and
a vacuum pump disposed at least partially within the enclosure and configured to draw the incondensable gasses into the second condenser.

8. The cooling system as set forth in any one of the preceding claims, wherein the first pump is configured to pump the refrigerant from the first condenser to the plurality of cold plates when the compressor is disengaged and the cooling system is operating in free cooling mode; and wherein the first pump is configured to pump the refrigerant from the evaporator to the plurality of cold plates when the compressor is engaged and the cooling system is operating in compression mode; or optionally
wherein the compressor is a centrifugal compressor; or optionally
wherein the compressor is configured to receive the refrigerant, in vapor form, from the plurality of cold plates and compress the refrigerant fluidically upstream of the first condenser; or optionally
wherein the second pump is configured to selectively pump the refrigerant from a first point below a liquid surface of the refrigerant in the first condenser, through the heat exchanger, and to a second point above the liquid surface of the refrigerant in the first condenser.

9. The cooling system as set forth in claim 8, further comprising a plurality of spray nozzles disposed at least partially within the first condenser, above the liquid surface, and configured to disperse the refrigerant entering the first condenser from the heat exchanger.

10. The cooling system as set forth in any one of the preceding claims, further comprising an overpressure sub-system disposed at least partially within the enclosure and configured to receive excess refrigerant, in liquid form, from upstream of the plurality of cold plates and selectively direct the excess refrigerant to the first condenser or the evaporator.

11. The cooling system as set forth in any one of the preceding claims, further comprising a vapor collector disposed at least partially within the enclosure and configured to receive the refrigerant, in vapor form, from the plurality of cold plates and selectively direct the refrigerant to the first condenser or the compressor.

12. The system as set forth in any one of the preceding claims, further comprising a filtration sub-system disposed at least partially within the enclosure.

13. The system as set forth in claim 12, wherein the filtration sub-system includes at least one media filter and at least one ultra-violet light; or optionally
wherein the filtration sub-system is fluidically coupled between the first pump and the plurality of cold plates.

14. The system as set forth in any one of the preceding claims, wherein the heat exchanger is configured to transfer heat from the refrigerant to a cooling fluid.

15. The system as set forth in claim 14, further comprising an external heat exchanger configured to reject, via the cooling fluid, at least a portion of the heat from the refrigerant into an environment outside of a building that houses the enclosure; or optionally
further comprising a heat recovery device configured to reject, via the cooling fluid, at least a portion of the heat from the refrigerant into a building that houses the enclosure.
